# EUROPÄISCHE PATENTSCHRIFT

(11) **EP 1 283 665 B1**
(45) Veröffentlichungstag und Bekanntmachung des Hinweises auf die Patenterteilung: **07.05.2008**
(21) Anmeldenummer: 02017150.0
(22) Anmeldetag: 30.07.2002
(51) Int. Cl.: H05K 5/00, H05K 5/02

(54) **Wandhalterung für ein elektrisches Gerät und elektrisches Gerät für eine solche Wandhalterung**
Wall support for an electrical apparatus and electrical apparatus for such a wall support
Support mural pour appareil électrique et appareil électrique pour un tel support mural

(30) Priorität: 31.07.2001 DE 10137501
(43) Veröffentlichungstag der Anmeldung: 12.02.2003
(73) Patentinhaber: Siemens Home and Office Communication Devices GmbH & Co. KG, 81379 München (DE)
(72) Erfinder: Goering, Klaus, 46399 Bocholt (DE); Gonser, Theodor, 81371 München (DE)
(74) Vertreter: Maier, Daniel Oliver

(56) Entgegenhaltungen:
- DE-A- 2 842 120
- DE-U- 8 901 019
- DE-U- 29 519 115
- US-A- 4 747 570

## Beschreibung

Die Erfindung betrifft eine Wandhalterung gemäß dem Oberbegriffe des Anspruchs 1 sowie ein elektrisches Gerät gemäß dem Oberbegriff des Anspruchs 6.

Basisstationen, heute in der Regel digital arbeitend, sind elektrische Geräte, die zur Übertragung von Daten und Sprache dienen. Es gibt Basisstationen, die entweder nur als Tischgerät oder nur als Wandgerät arbeiten. Es gibt aber auch Basisstationen, die sowohl als Tischgerät als auch als Wandgerät arbeiten. Insbesondere die zuletzt angesprochenen Basisstationen weisen für den Betrieb als Tischgerät eine mit Gerätefüßen versehene Standfläche auf. Für den Betrieb als Wandgerät gibt es, wenn die Oberfläche des Geräts nicht schon integrierte Wandbefestigungshalter hat, separate Wandhalterungen, die an der Wand befestigt werden können und die einen mechanischen Befestigungsmechanismus haben, in den die Basisstation eingebracht und dort befestigt werden kann. Damit die Basisstation in den mechanischen Befestigungsmechanismus der Wandhalterung eingebracht und dort befestigt werden kann, weist die Basisstation einen entsprechenden mechanischen Gegenmechanismus auf.

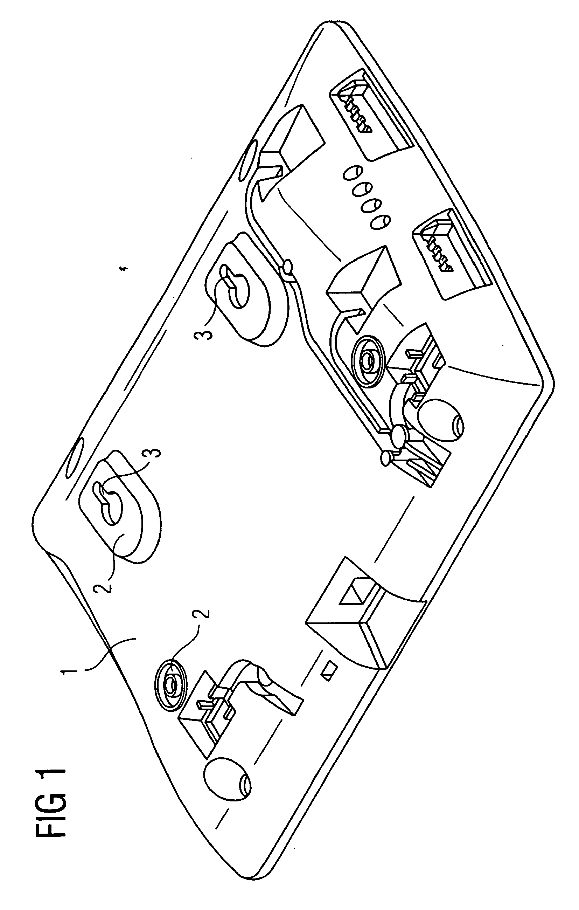

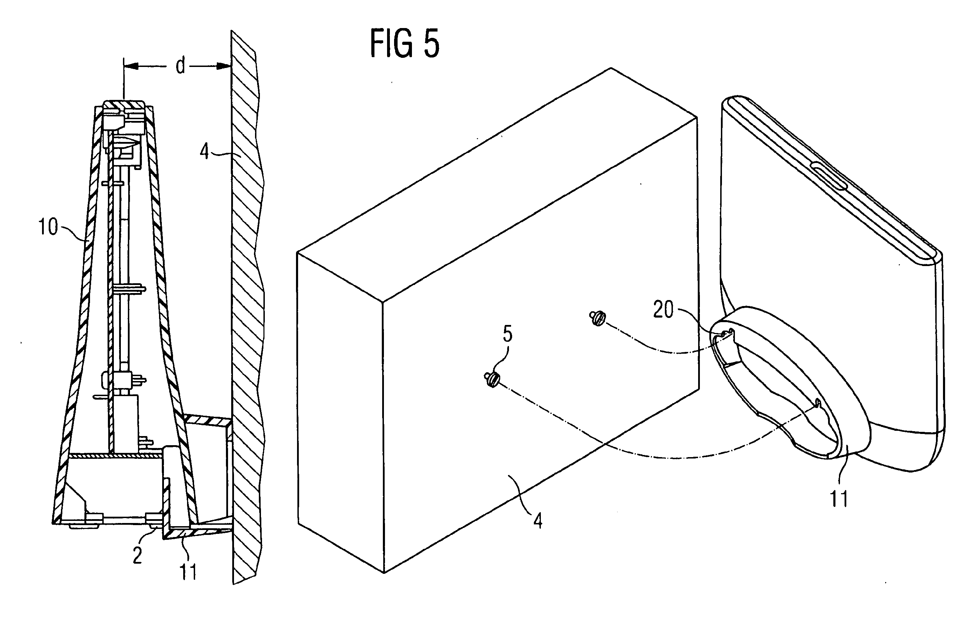

In der Figur 1 ist eine Basisstation 1 gemäß dem Stand der Technik gezeigt, die sowohl als Tischgerät als auch als Wandgerät eingesetzt werden kann. Im Tischbetrieb steht die Basisstation 1 auf Gerätefüßen 2. Im Wandbetrieb hängt die Basisstation 1 mit Hilfe von in der Oberfläche integrierten Wandbefestigungshaltern 3 an einer Wand 4 (Figur 5). Dazu weisen die Wandbefestigungshalter 3 Langlöcher auf, mit denen die Basisstation 1 an vormontierten Schrauben 5 (Figur 5) an der Wand eingehängt und befestigt werden kann.

Gemäß der Figur 1 sind die Wandbefestigungshalter 3 in der Weise konzipiert, dass sie gleichzeitig auch als Gerätefüße 2 verwendbar sind.

Im Wandbetrieb ist ein Mindestabstand d (Figur 5) zwischen der Basisstation 1 und der Wand 4 (Figur 5) einzuhalten. Damit wird ausgeschlossen, dass die Wandmaterialien einen Einfluss auf die Antennencharakteristik der Basisstation 1 haben (Reichweitenproblem).

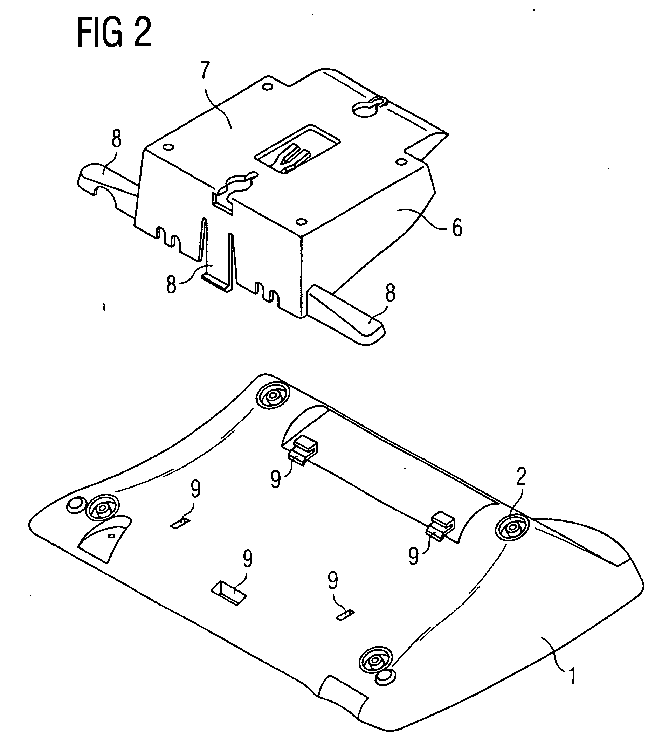

Wenn die Wandbefestigungshalter 3 zusammen mit einer entsprechend geformten Oberfläche der Basisstation 1 diesen Mindestabstand nicht sicherstellen, dann sind separate Wandhalterungen 6 notwendig, wie sie beispielhaft in der Figur 2 gezeigt sind.

Gemäß der Figur 2 weist die Wandhalterung 6 eine Wand-Auflageebene 7 auf, mit der sie einerseits an einer Wand 4 (Figur 5) befestigt wird und an der andererseits ein mechanischer Befestigungsmechanismus 8 für die Aufnahme und Befestigung der Basisstation 1 an der Wandhalterung 6 vorgesehen ist. Zur Aufnahme und Befestigung der Basisstation 1 an der Wandhalterung 6 weist die Basisstation 1 einen entsprechenden mechanischen Gegenmechanismus auf, der gemäß der Figur 2 durch Haltepunkte 9 im Gehäuse der Basisstation 1 realisiert ist.

Wie den Figuren 1 und 2 zu entnehmen ist, kann nicht ausgeschlossen werden, dass die mechanischen Befestigungsmechanismen bzw. Teile davon im Einsatzfall der Geräte gesehen werden. Dies soll bei neuen Lösungen vermieden werden. Insbesondere soll aus gestalterischen Gründen vermieden werden, dass Aufnahmelöcher für benötigte Halteschrauben direkt in der sichtbaren Gehäuseoberfläche des Gerätes angeordnet sind. Werden separate Wandhalterungen eingesetzt, dürfen keine Öffnungen wie zum Beispiel Verrastungsschlitze u.s.w. am Gerät sichtbar sein. Eine weitere Anforderung ist, dass die Umstellung von einem Tisch- zu einem Wandbetrieb bzw. umgekehrt für eine Person unkompliziert und handlich ist, das heißt, durch die Person ohne Werkzeug zu bewerkstelligen ist. Außerdem soll eine sichere Führung von Anschlussschnüren gewährleistet sein.

Eine Wandhalterung, wie sie in den Figuren 1 und 2 beschrieben ist, ist aus dem Dokument DE-U-295 19 115 bekannt.

Aufgabe der vorliegenden Erfindung ist es deshalb, ausgehend von einer Wandhalterung der eingangs genannten Art eine Wandhalterung anzugeben, die die vorgenannten Kriterien erfüllt. Außerdem ist es Aufgabe der vorliegenden Erfindung, ein elektrisches Gerät anzugeben, das zusammen mit der erfindungsgemäßen Wandhalterung verwendbar ist.

Der erste Teil der Aufgabe wird erfindungsgemäß durch eine Wandhalterung gelöst, die die Merkmale des Anspruchs 1 aufweist. Der zweite Teil der Aufgabe wird durch ein elektrisches Gerät gelöst, das die Merkmale des Anspruchs 6 aufweist.

Die erfindungsgemäße Wandhalterung benötigt Öffnungen an einem zugehörigen elektrischen Gerät, die beispielsweise an einer Bodenfläche des betreffenden elektrischen Geräts angeordnet sind. Zur Bodenfläche ist in der Regel eine jegliche Sicht versperrt. Bei einem Tischbetrieb steht das betreffende Gerät auf der besagten Bodenfläche und es ist keine Sicht möglich. Bei einem Wandbetrieb ist eine Sicht auf die Bodenfläche ebenfalls nicht ohne weiteres möglich. Außerdem hat die erfindungsgemäße Wandhalterung eine Sichtverblendung, die die Sicht auf die Bodenfläche zumindest nochmals einengt.

Die Öffnungen könnten auch, wenn die Wandhalterung entsprechend ausgebildet wäre, an einer Deckfläche des betreffenden elektrischen Geräts angeordnet sein. Dieser Sachverhalt träfe beispielsweise dann zu, wenn die stabartigen Zapfen im montierten Zustand der Wandhalterung in eine nach unten gerich tete Richtung an dem Haltemittel angeordnet wären. In diesem Fall wäre dann das elektrische Gerät nicht von oben auf die Wandhalterung zu setzen sondern von unten an die Wandhalterung zu stecken. In diesem Fall wäre dann beim Wandbetrieb des elektrischen Geräts die Sicht auf die Deckfläche des elektrischen Geräts durch die Sichtverblendung der Wandhalterung verdeckt. Im Tischbetrieb könnte die Sicht auf die Deckfläche durch eine abnehmbare Haube verhindert sein.

Durch den Einsatz von stabartigen Zapfen ist die Befestigung bzw. das Lösen eines betreffenden elektrischen Gerätes an der Wandhalterung bzw. von der Wandhalterung so einfach und unkompliziert, dass diese Vorgänge ohne Werkzeughilfe möglich ist. Das betreffende elektrische Gerät braucht nur auf die Zapfen gesetzt bzw. an die Zapfen gesteckt zu werden. Im umgekehrten Fall braucht das betreffende elektrische Gerät nur von den Zapfen abgenommen bzw. abgezogen zu werden.

Die in der Wandhalterung vorgesehene Leitungsdurchführungsmöglichkeit gewährleistet eine sichere Leitungsführung.

Vorteilhafte Ausgestaltungen der Erfindung sind Gegenstand von Unteransprüchen.

Danach werden mindestens zwei stabartige Zapfen zur Befestigung eines betreffenden Gerätes vorgesehen, die gegenüber beispielsweise einem Einzelzapfen eine entsprechend vergrößerte Haltekraft aufbringen. Ferner werden an den stabartigen Zapfen zurückfederbare Rasthaken vorgesehen, durch die eine wieder lösbare Einrastfunktion realisiert ist. Dadurch ist ein versehentliches bzw. eigenständiges Abgleiten von den stabartigen Zapfen in jedem Fall verhindert. Trotzdem kann ein betreffendes elektrisches Gerät in einfacher Weise wieder gelöst werden. Außerdem kann dann insbesondere bei einer Lösung, bei der ein betreffendes elektrisches Gerät nicht von oben kommend auf die stabartigen Zapfen gesetzt sondern umgekehrt von unten kommend an die stabartigen Zapfen gesteckt wird, auf einen möglicherweise verwendeten Klemmsitz verzichtet werden.

Weist die Wand-Auflageebene auf Seiten zu einem von der Wandhalterung aufgenommenen und befestigten elektrischen Gerät hin einen Materialverlauf auf, der unmittelbar und direkt an den Konturenverlauf der Oberfläche des aufgenommenen und befestigten elektrischen Geräts angepasst ist, verschmilzt optisch die Oberfläche der Wandhalterung mit der Oberfläche des betreffenden elektrischen Gerät zu einer einzigen Oberfläche und die Gesamtheit bildet optisch eine Einheit.

Sind die stabartigen Zapfen im montierten Zustand der Wandhalterung in eine nach oben gerichtete Richtung an dem Halteelement angeordnet, lässt sich besonders einfach die Sicht auf unschöne Haltepunkte für die Verbindung zwischen einem betreffenden elektrischen Gerät und der Wandhalterung verdecken.

Ist der Durchbruch durch die Wand-Auflageebene so groß genug, um einen Stromstecker hindurch zu reichen, kann auf eine ansonsten eventuell benötigte Demontage und anschließende Montage des Stromsteckers verzichtet werden.

Es ist vorteilhaft, wenn elektrische Geräte als Basisstationen für die Übertragung von Sprache und Daten ausgebildet sind, da diese Geräte immer mehr in Haushalten zum Einsatz kommen und dort zu stationieren sind, wobei sie sich oft im sichtbaren Bereich befinden und daher optisch ansprechend auszusehen haben.

Nachfolgend wird ein Ausführungsbeispiel der Erfindung anhand einer Zeichnung näher erläutert. Darin zeigen:
- Figur 1: eine erste Ausführungsform einer Basisstation mit einer integrierten Wandhalterung gemäß dem Stand der Technik,
- Figur 2: eine zweite Ausführungsform einer Basisstation mit einer separaten Wandhalterung gemäß dem Stand der Technik,
- Figur 3: eine dritte Ausführungsform einer Basisstation gemäß der Erfindung im Zusammenhang mit einer Wandhalterung gemäß der Erfindung,
- Figur 4: eine Basisstation gemäß der Erfindung mit einem Fokus auf erfindungswesentliche Details, und
- Figur 5: eine teilweise in Schnittdarstellung ausgeführte Montageskizze einer erfindungsgemäßen Basisstation und einer erfindungsgemäßen Wandhalterung.

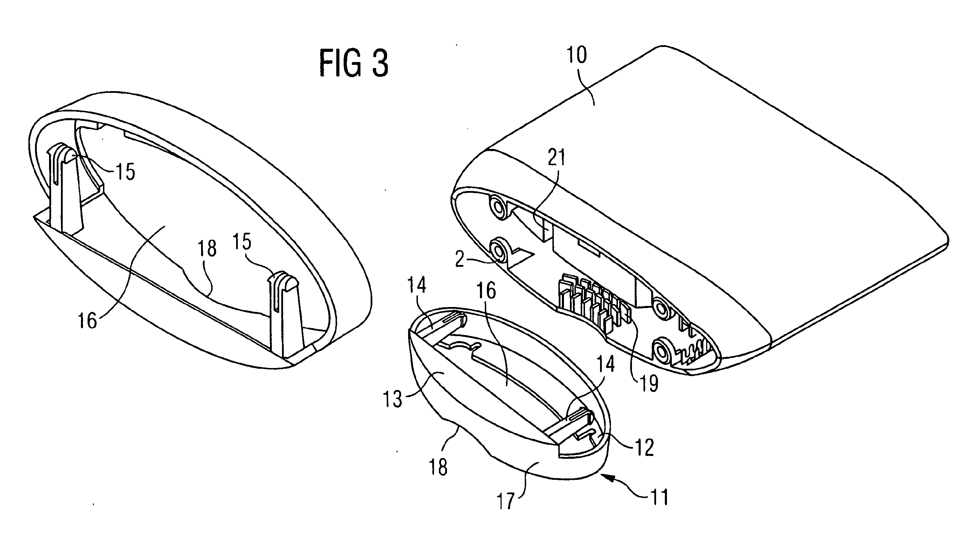

In der Figur 3 ist eine Basisstation 10 als elektrisches Gerät gezeigt, die als Standgerät konzipiert ist und als solches eine Bodenfläche aufweist, die für das Gerät eine Standfläche ist. An der Standfläche sind verdeckt Gerätefüße 2 angeordnet, auf die die Basisstation 10 als Tischgerät gestellt werden kann.

Der Basisstation 10 ist eine separate Wandhalterung 11 zugeordnet. Sie besteht aus einem zylindrischen Grundkörper mit elliptischer Basisfläche, die auch als eine Wand-Auflageebene 12 aufgefasst werden kann.

Der zylindrische Grundkörper hat einen Ausschnitt für die Auflage der Basisstation 10. Der Ausschnitt ergibt sich mit anderen Worten daraus, dass wenigstens im wesentlichen senkrecht zur Wand-Auflageebene 12 wenigstens ein einziges Haltemittel 13 starr absteht.

Gemäß der Figur 3 ist dieses Haltemittel 13 in der Weise ausgebildet, dass es eine Ebene umfasst. Diese Ebene bildet eine Gegenlage für die in die Wandhalterung 11 eingebrachte Basisstation 10. An dem Haltemittel 13 sind gleichmäßig verteilt zwei wenigstens im wesentlichen senkrecht zum Haltemitte 13 angeordnete stabartige Zapfen 14 starr befestigt.

An den freien Enden der stabartigen Zapfen 14 sind zurückfederbare Rasthaken 15 angeordnet. Die zurückfederbaren Rasthaken 15 bewerkstelligen bei der Aufnahme und Befestigung der Basisstation 10 eine wieder lösbare Rastfunktion.

Die Basisstation 10 weist verdeckt an der Bodenfläche Öffnungen 21 zur Aufnahme der stabartigen Zapfen 14 auf. Beim Einbringen der Basisstation 10 in den Ausschnitt der Wandhalterung 11 greifen die stabartigen Zapfen 14 in die an der Bodenfläche der Basisstation 10 vorhandenen Öffnungen 21 ein und können darin wieder lösbar verrasten. Für einen Toleranzausgleich federt die Basisstation 10 auf den Gerätefüßen 2 gegenüber der Wandhalterung 11 ab.

Mit dem Verrasten der stabartigen Zapfen 14 wird die Basisstation 10 von der Wandhalterung 11 festgehalten. Denkbar wäre auch eine Lösung, bei der die stabartigen Zapfen 14 eine Art Quetschsitz realisieren.

Gemäß der Figur 3 sind das Haltemittel 13 senkrecht von der Wand-Auflageebene 12 und sind die stabartigen Zapfen 14 jeweils senkrecht zum Haltemittel 13 angeordnet. Denkbar wäre im einzelnen auch eine nicht senkrechte Lösung, wobei dann die Kanäle der Öffnungen 21 an der Bodenfläche der Basisstation 10 und die Einführrichtung der Basisstation 10 in die Wandhalterung 11 entsprechend schräg ausgeführt sein müssten.

Die Wand-Auflageebene 12 weist einen Durchbruch 16 für die Durchführung beispielsweise eines Kabels auf.

Auf der der Seite mit den stabartigen Zapfen 15 entgegengesetzt angeordneten Seite des Haltemittels 13 ist eine Sichtverblendung 17 zu den stabartigen Zapfen 14 hin ausgebildet.

Auf der einer in der Figur 3 nicht näher dargestellten Wand zugeordneten Seite der Wand-Auflageebene 12 weist der Materialverlauf an einer ausgewählten Stelle, die im vorliegenden Fall im Gebiet der Sichtverblendung 17 liegt, in der Weise eine Zurücknahme 18 auf, dass durch diese Zurücknahme 18 des Materialverlaufs eine Leitungsdurchführungsmöglichkeit gegeben ist.

Der durch die Wand-Auflageebene 12 und das Haltemittel 13 gebildete Ausschnitt ist der Oberflächenkontur einer Eingesetzten Basisstation 10 unmittelbar und direkt angepasst.

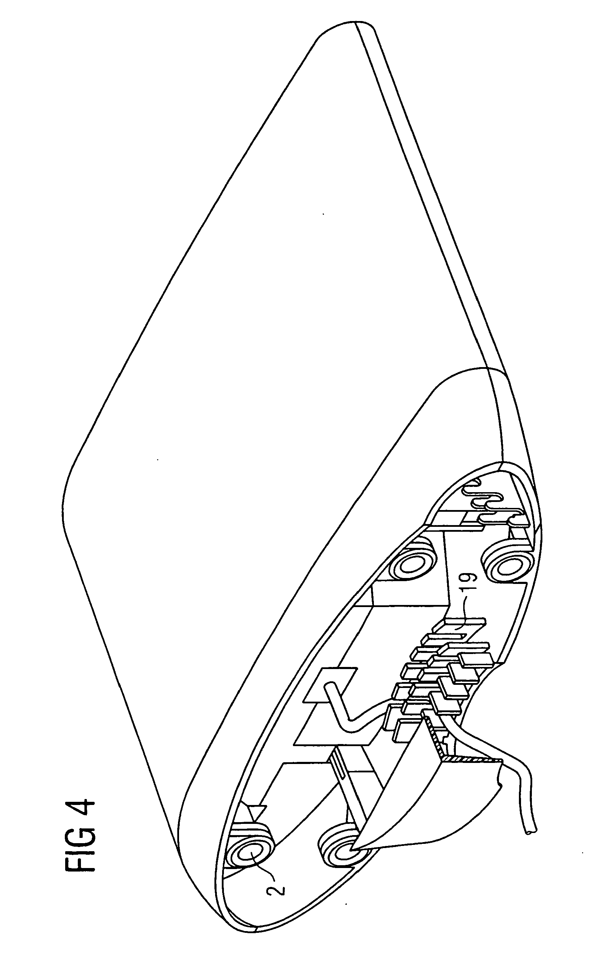

Die Basisstation 10 weist an der Bodenfläche Führungsrippen 19, wie das in der Figur 4 näher dargestellt ist, für die Kabelführung auf.

Wie die Figur 5 näher zeigt, hat die Wandhalterung 11 rückseitig Freinehmungen 20 für wandseitig vormontierte Schrauben 5.

Figur 5 zeigt darüber hinaus eine Schnittdarstellung der Gesamtanordnung, das heißt einer an einer Wand 4 befestigten Wandhalterung 11 und einer in der Wandhalterung 11 befestigten Basisstation 10. Wie die Figur 5 insbesondere zeigt, dient die Wandhalterung 11 gleichzeitig als ein Abstandshalter zur Wand 4, durch die ein Mindestabstand d zwischen der Basisstation 10 und der Wand 4 eingehalten wird.

## Patentansprüche

1. Wandhalterung mit einer Wand-Auflageebene zur Befestigung an einer Wand und einem mechanischen Befestigungsmechanismus für die wieder entnehmbare Aufnahme und Befestigung eines in den mechanischen Befestigungsmechanismus eingebrachten, einen entsprechenden mechanischen Gegenmechanismus aufweisenden elektrischen Geräts, **dadurch gekennzeichnet, dass** wenigstens im wesentlichen senkrecht zur Wand-Auflageebene (12) wenigstens ein einziges Haltemittel (13) starr absteht, an dem wenigstens ein einziger wenigstens im wesentlichen senkrecht zum Haltemittel (13) angeordneter stabartiger Zapfen (14) starr befestigt ist, der bei der Aufnahme und Befestigung des elektrischen Geräts (10) in eine Gegenöffnung (21) des mechanischen Gegenmechanismus des elektrischen Geräts (10) eintaucht und dadurch das elektrische Gerät (10) festhält, dass die Wand-Auflageebene (12) einen Durchbruch (16) durch die Wand-Auflageebene (12) hindurch aufweist, dass auf der der Seite mit den stabartigen Zapfen (14) entgegengesetzt angeordneten Seite des Haltemittels (13) eine Sichtverblendung (17) zu den stabartigen Zapfen (14) hin angeordnet ist, und dass der Materialverlauf der Wand-Auflageebene (12) auf der einer Wand zugeordneten Seite an einer ausgewählten Stelle eine eine Leitungsdurchführungsmöglichkeit bildende Zurücknahme (18) aufweist.

2. Wandhalterung nach Anspruch 1, **dadurch gekennzeichnet, dass** das Haltemittel (13) im wesentlichen eine Ebene umfasst, auf der gleichmäßig verteilt zwei stabartige Zapfen (14) starr befestigt sind, die an den freien Enden zurückfederbare Rasthaken (15) haben, durch die bei der Aufnahme und Befestigung eines elektrischen Geräts (10) eine wieder lösbare Rastfunktion bewerkstelligt ist.

3. Wandhalterung nach Anspruch 1 oder 2, **dadurch gekennzeichnet, dass** die Wand-Auflageebene (12) auf Seiten zu einem aufgenommenen und befestigten elektrischen Gerät (10) hin einen Materialverlauf aufweist, der unmittelbar und direkt an den Konturenverlauf der Oberfläche des aufgenommenen und befestigten elektrischen Geräts (10) angepasst ist.

4. Wandhalterung nach einem der vorherigen Ansprüche, **dadurch gekennzeichnet, dass** die stabartigen Zapfen (14) im montierten Zustand der Wandhalterung (11) in eine nach oben gerichtete Richtung an dem Haltemittel (13) angeordnet sind.

5. Wandhalterung nach einem der vorherigen Ansprüche, **dadurch gekennzeichnet, dass** der Durchbruch (16) durch die Wand-Auflageebene (12) zumindest eine Größe für einen Durchgriff eines Stromsteckers hat.

6. Elektrisches Gerät für eine Wandhalterung gemäß einem der Ansprüche 1 bis 5, **dadurch gekennzeichnet, dass** das elektrische Gerät zum mechanischen Befestigungsmechanismus der besagten Wandhalterung (11) einen passenden mechanischen Gegenmechanismus aufweist in der Weise, dass der Gegenmechanismus für die im montierten Zustand der Wandhalterung entweder in eine nach unten oder in eine nach oben gerichtete Richtung angeordneten stabartigen Zapfen (14) des Befestigungsmechanismus der Wandhalterung nach einem der Ansprüche 1 bis 5 Gegenöffnungen (21) umfasst, in die bei der Aufnahme und Befestigung des elektrischen Geräts (10) in die Wandhalterung nach einem der Ansprüche 1 bis 5 die stabartigen Zapfen (14) eintauchen.

7. Elektrisches Gerät nach Anspruch 6, **dadurch gekennzeichnet, dass** das elektrische Gerät als eine Basisstation (10) für die Übertragung von Sprache und Daten ausgebildet ist.

## Claims

1. Wall support with a wall contact plane for securing to a wall and a mechanical securing mechanism for the releasable holding and securing of an electrical device inserted into the mechanical securing mechanism and having a corresponding counter-mechanism, **characterised in that** at least a single holding means (13) projects rigidly at least essentially perpendicular to the wall contact plane (12), to which holding means (13) at least a single rod-like pin (14) arranged at least essentially perpendicular to the holding means (13) is rigidly secured, which engages in a counter-opening (21) of the mechanical counter-mechanism of the electrical device (10) when the electrical device (10) is held and secured and as a result of which the electrical device (10) is held firmly, the wall contact plane (12) has a hole (16) through the wall contact plane (12), a facing (17) is arranged towards the rod-like pins (14) on the side of the holding means (13) opposite the side with the rod-like pins (14) and the material pattern of the wall contact plane (12) on the side assigned to a wall has a retraction (18) forming a line guidance option at a selected point.

2. Wall support according to claim 1, **characterised in that** the holding means (13) essentially comprises a plane, on which two rod-like pins (14) are rigidly secured in an evenly distributed manner, having latching hooks (15) that spring back at their free ends, by means of which a releasable latching function is realised when an electrical device (10) is held and secured.

3. Wall support according to claim 1 or 2, **characterised in that** the wall contact plane (12) has a material pattern at the sides towards a held and secured electrical device (10), said material pattern being tailored immediately and directly to the contour pattern of the surface of the held and secured electrical device (10).

4. Wall support according to one of the preceding claims, **characterised in that** the rod-like pins (14) are arranged in an upward facing direction on the holding means (13) in the assembled state of the wall support (11).

5. Wall support according to one of the preceding claims, **characterised in that** the hole (16) through the wall contact plane (12) is at least of a size to allow passage of a power outlet.

6. Electrical device for a wall support according to one of claims 1 to 5, **characterised in that** the electrical device has a mechanical counter-mechanism matching the mechanical securing mechanism of the said wall support (11) in such a manner that the counter-mechanism comprises counter-openings (21) for the rod-like pins (14) of the securing mechanism of the wall support according to one of claims 1 to 5, said rod-like pins (14) being arranged either in a downward facing direction or in an upward facing direction in the assembled state of the wall support, in which counter-openings (21) the rod-like pins (14) engage when the electrical device (10) according to one of claims 1 to 5 is held and secured in the wall support.

7. Electrical device according to claim 6, **characterised in that** the electrical device is configured as a base station (10) for transmitting voice and data.

## Revendications

1. Support mural comprenant un plan d'appui au mur pour la fixation sur un mur et un mécanisme de fixation mécanique pour le logement de nouveau amovible et pour la fixation d'un appareil électrique présentant un contre-mécanisme mécanique correspondant placé dans le mécanisme de fixation mécanique, **caractérisé en ce qu'**au moins un seul moyen de maintien (13) dépasse de manière rigide au moins essentiellement verticalement par rapport au plan d'appui au mur (12), sur lequel moyen de maintien au moins un seul tourillon (14) en forme de barre, disposé au moins essentiellement verticalement par rapport au moyen de maintien (13), est fixé de manière rigide, le tourillon s'enfonçant dans une contre-ouverture (21) du contre-mécanisme mécanique de l'appareil électrique (10) lors du logement et de la fixation de l'appareil électrique (10) et maintenant ainsi l'appareil électrique (10), **en ce que** le plan d'appui au mur (12) présente un passage (16) à travers le plan d'appui au mur (12), **en ce que** sur le côté, opposé au côté comprenant le tourillon (14) en forme de barre, du moyen de maintien (13) est disposé un cache (17) en direction du tourillon (14) en forme de barre, et **en ce que** l'allure de matériau du plan d'appui au mur (12) présente à un endroit sélectionné sur le côté attribué au mur un retour (18) formant une possibilité de passage de ligne.

2. Support mural selon la revendication 1, **caractérisé en ce que** le moyen de maintien (13) présente essentiellement un plan sur lequel deux tourillons (14) en forme de barre sont fixés de manière rigide en étant répartis régulièrement, qui, sur les extrémités libres, ont des crans d'arrêt (15) pouvant se détendre en retour, au moyen desquels une fonction d'enclenchement de nouveau amovible est réalisée lors du logement et de la fixation d'un appareil électrique (10).

3. Support mural selon la revendication 1 ou 2, **caractérisé en ce que** le plan d'appui au mur (12), sur les côtés tournés vers un appareil électrique (10) logé et fixé, présente une allure de matériau qui est adaptée directement à l'allure du contour de la surface de l'appareil électrique (10) logé et fixé.

4. Support mural selon l'une quelconque des revendications précédentes, **caractérisé en ce que** les tourillons (14) en forme de barre, à l'état monté du support mural (11), sont disposés sur le moyen de maintien (13) dans une direction dirigée vers le haut.

5. Support mural selon l'une quelconque des revendications précédentes, **caractérisé en ce que** le passage (16) à travers le plan d'appui au mur (12) a au moins une taille pour un passage d'un connecteur électrique.

6. Appareil électrique pour support mural selon l'une quelconque des revendications 1 à 5, **caractérisé en ce que** l'appareil électrique, par rapport au mécanisme de fixation mécanique du dit support mural (11), présente un contre-mécanisme mécanique approprié, de manière à ce que le contre-mécanisme, pour les tourillons (14) en forme de barre, disposés soit dans une direction vers le bas soit dans une direction vers le haut à l'état monté du support mural, du mécanisme de fixation du support mural selon l'une quelconque des revendications 1 à 5, comprenne des contre-ouvertures (21) dans lesquelles les tourillons (14) en forme de barre s'enfoncent lors du logement et de la fixation de l'appareil électrique (10) dans le support mural selon l'une quelconque des revendications 1 à 5.

7. Appareil électrique selon la revendication 6, **caractérisé en ce que** l'appareil électrique est exécuté en tant qu'une station de base (10) pour la transmission de la voix et de données.
